# EUROPEAN PATENT APPLICATION

(11) **EP 4 478 272 A1**
(43) Date of publication of application: **18.12.2024**
(21) Application number: 23179075.9
(22) Date of filing: 13.06.2023
(51) Int. Cl.: G06Q 10/10

(54) **AI-BASED REQUIREMENTS ENGINEERING AND RECOMMENDATION PLATFORM FOR CONSTRUCTION AND RENOVATION PROJECTS**

(71) Applicant: Palasts GmbH, 73457 Essingen (DE)
(72) Inventor: Dowling, Leonie, 73457 Essingen (DE)
(74) Representative: Meyer zu Bexten, Elmar

(57) **Abstract**

Computer-implemented method for generating automated planning and design recommendations for buildings, the method comprising
- implementing at least one computer vision model
- implementing at least one natural language processing model
- training the computer vision model(s) and/or language processing model(s) using special data sets
- preparing at least one questionnaire containing questions based on the trained computer vision model(s) and/or language processing model(s)
- presenting the questionnaire(s) to a user and recording his answers
- generate recommendations and/or additional questions to the user

## Description

### Technical Field

The invention pertains to the process and products as per the first portion of the independent claims.

### Background Art

Building projects often get extremely expensive, delayed, or completely fail due to lack of clear objectives and requirements. Presently, in various portals or with various 2D and 3D planning software, architects and planners are given the possibility to plan the architecture of buildings and/or its furnishings / interior. Usually, these are pure "drawing programs" that make it easy to place walls, furniture, etc.

Starting to plan and design a building (new or renovation) assumes a high degree of knowledge about the needs of the decision takers, the future users, and all relevant stakeholders. This is often not the case - on the principals, architects, and project managers side - as it includes extremely high efforts to collect, process and continuously manage all the complex requirements, which are above all often contradictory. Poor requirements often end in endless change requests which are both time-consuming and expensive for the principal/investor.

Until today, there is no such platform that enables architects and principals to analyze requirements in detail and turn them into automated holistic planning and design suggestions. Our solution helps define the right objectives and requirements right from the beginning, so that project objectives regarding time, quality, budget, and customer satisfaction can be achieved better.

### Summary of Invention

The invention, which is defined in detail in the appended independent claims, is hereinafter disclosed in such a way that the technical problem with which it deals can be appreciated and the solution can be understood.

**Technical Problem:** To provide a requirements engineering platform for architects, planners & principals and similar in order to generate automated planning and design recommendations for buildings.

**Solution to Problem:** The problem is solved as per the second portion of the independent claims.

**Advantageous effect and technical applicability of invention:** The invention integrates rational/functional elements, planning/design elements as well as intuitive/emotional criteria into objective criteria for planning and design in 2D and 3D for construction, renovation and building optimization projects. Further, the invention significantly reduces the amount of time needed for professional architects and planners to obtain such criteria from their clients and thereby significantly improves the cost-effectiveness of the planning process.

### Brief Description of Drawings

[Fig.1] shows an overview of the invention from the user's point of view.
[Fig.2] shows the interconnections of various modules in an embodiment of the invention.
[Fig.3] shows the Al engine modules.
[Fig.4] a-b shows flow diagrams of exemplary modules in an embodiment of the invention.

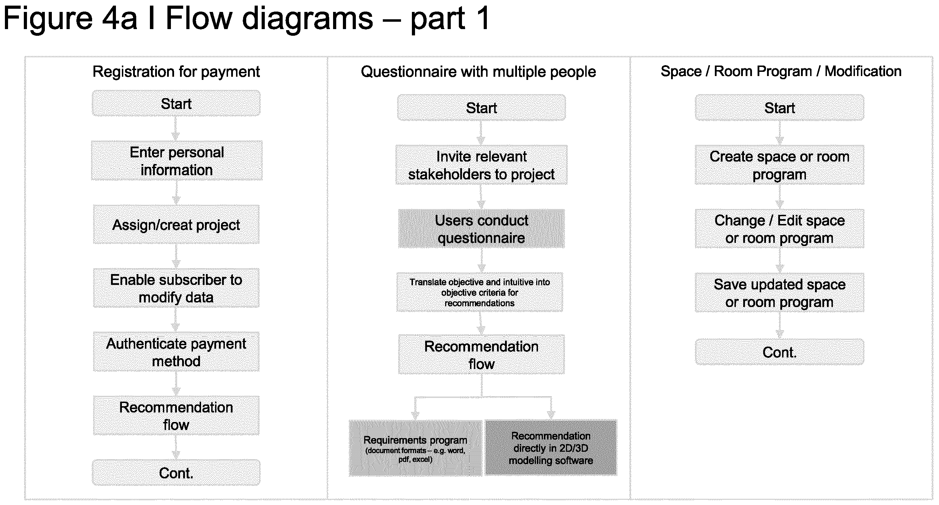

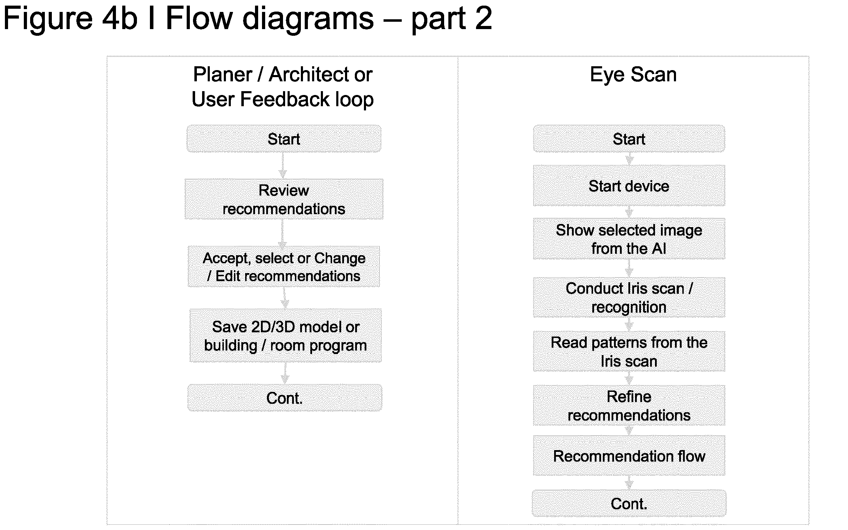

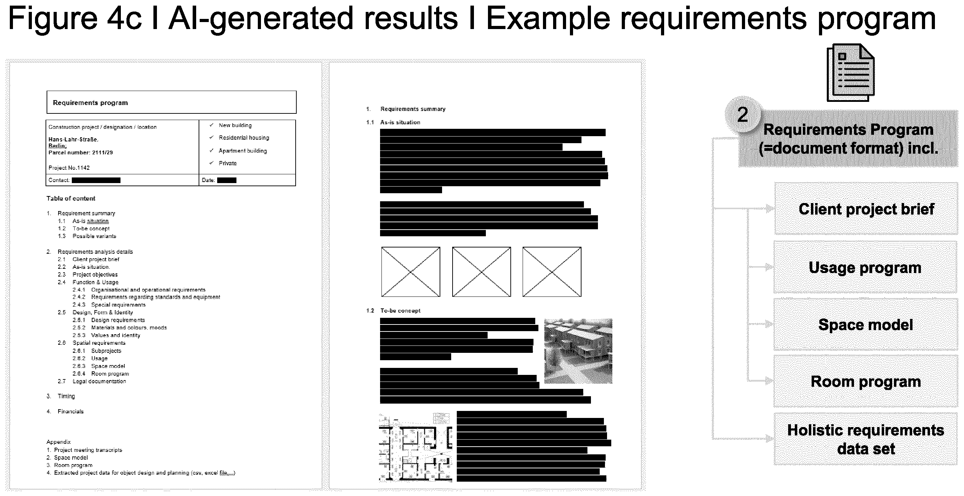

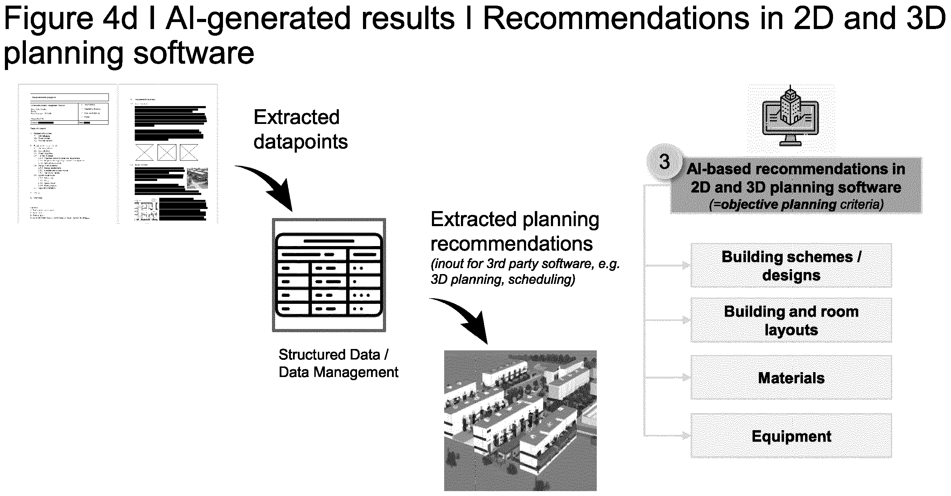

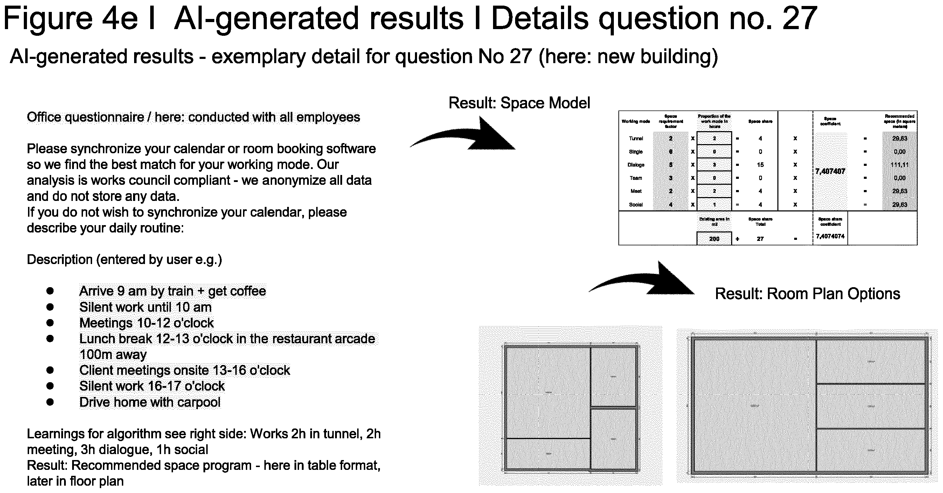

[Fig.4] c-e shows examples of the Al-generated results.

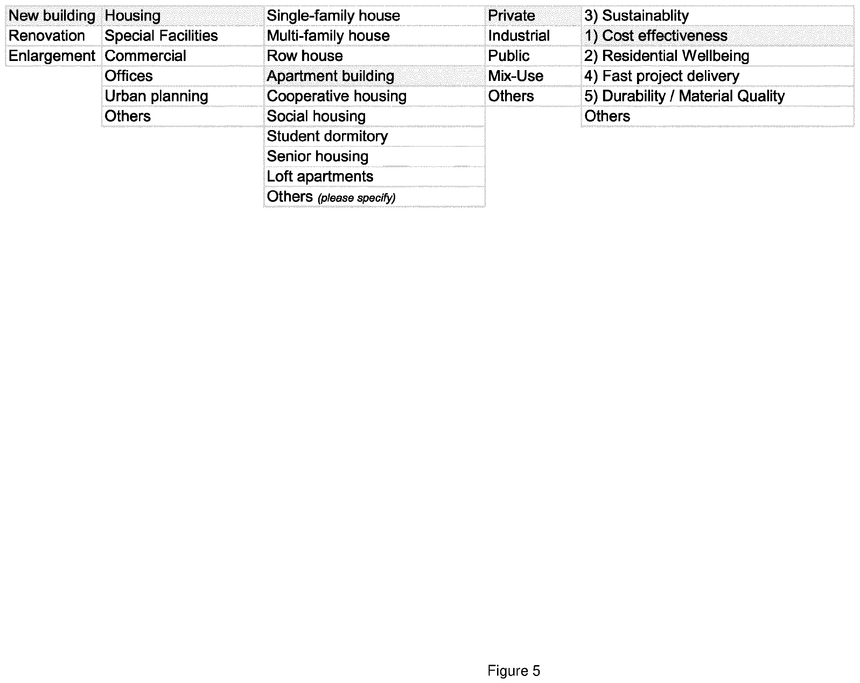

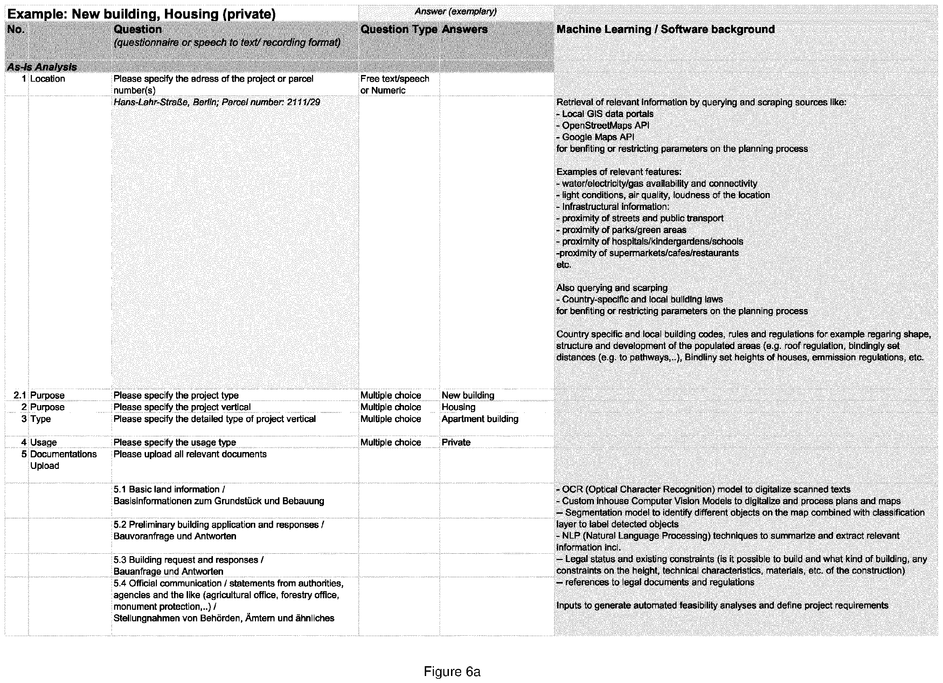

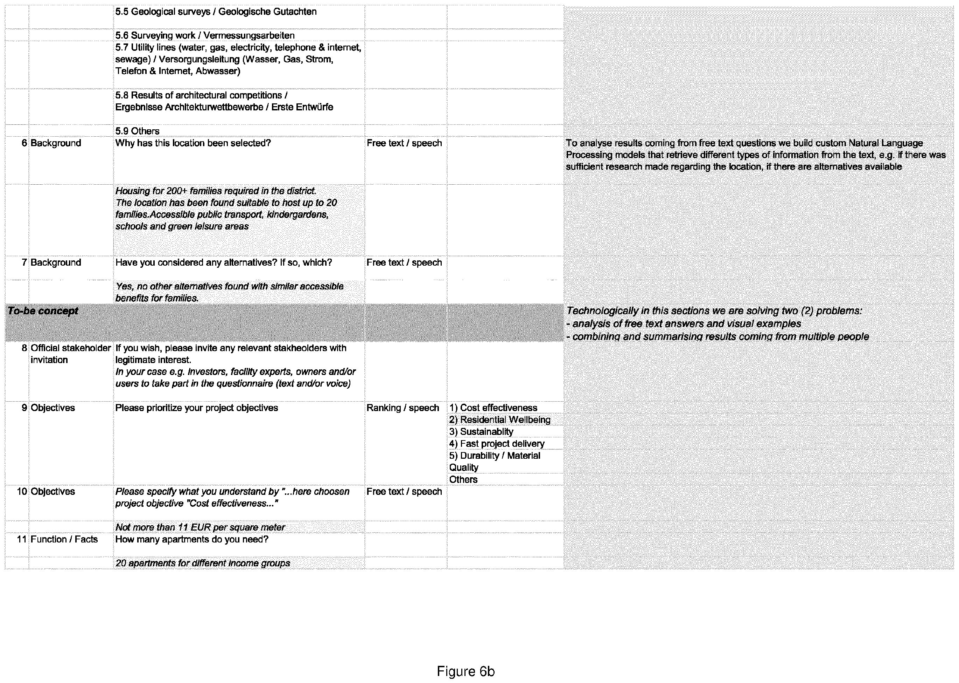

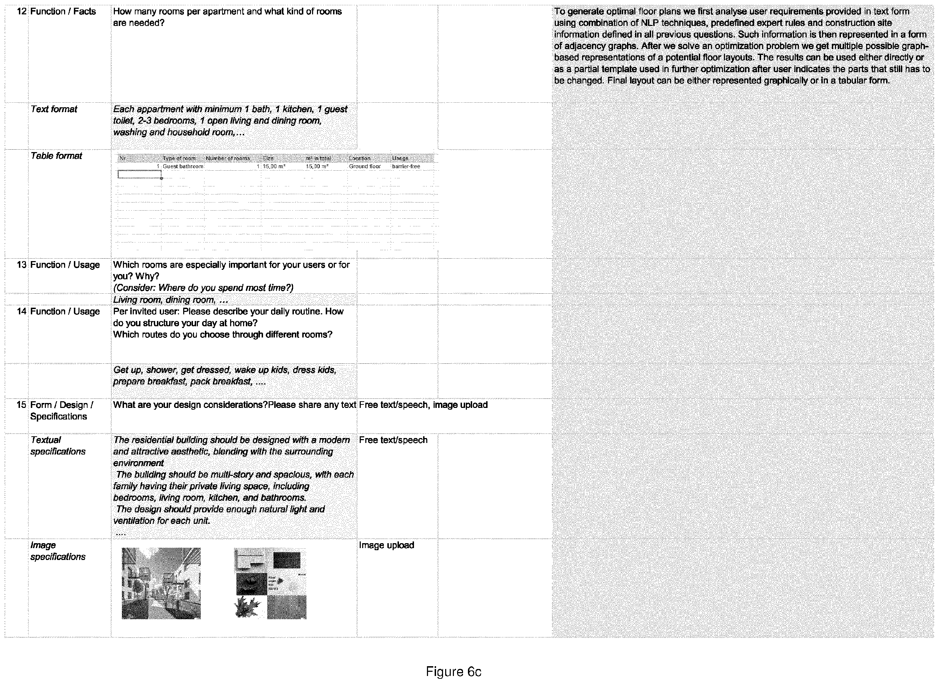

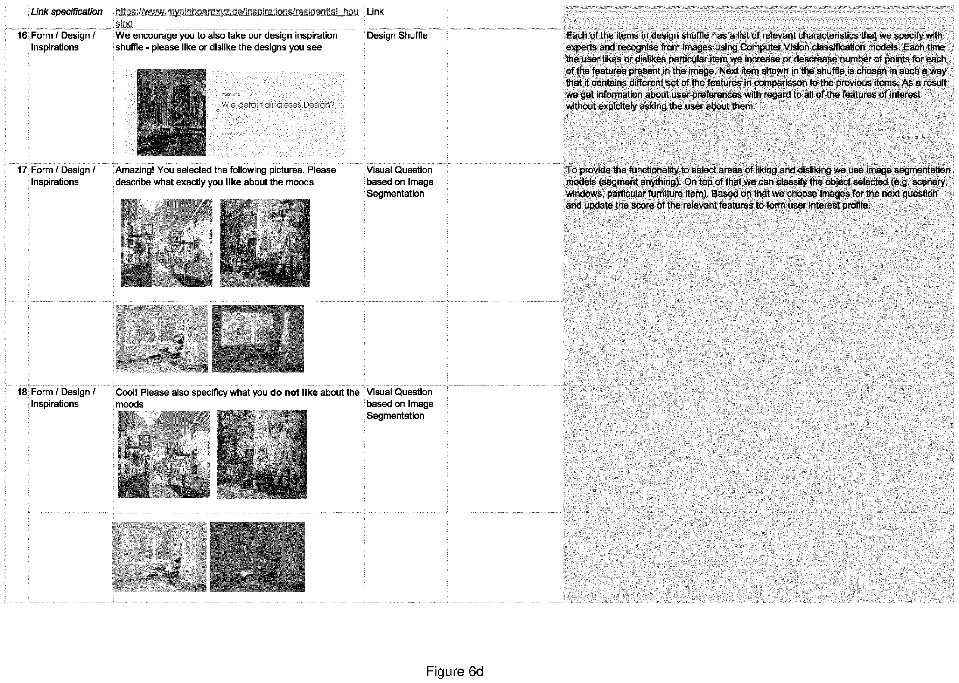

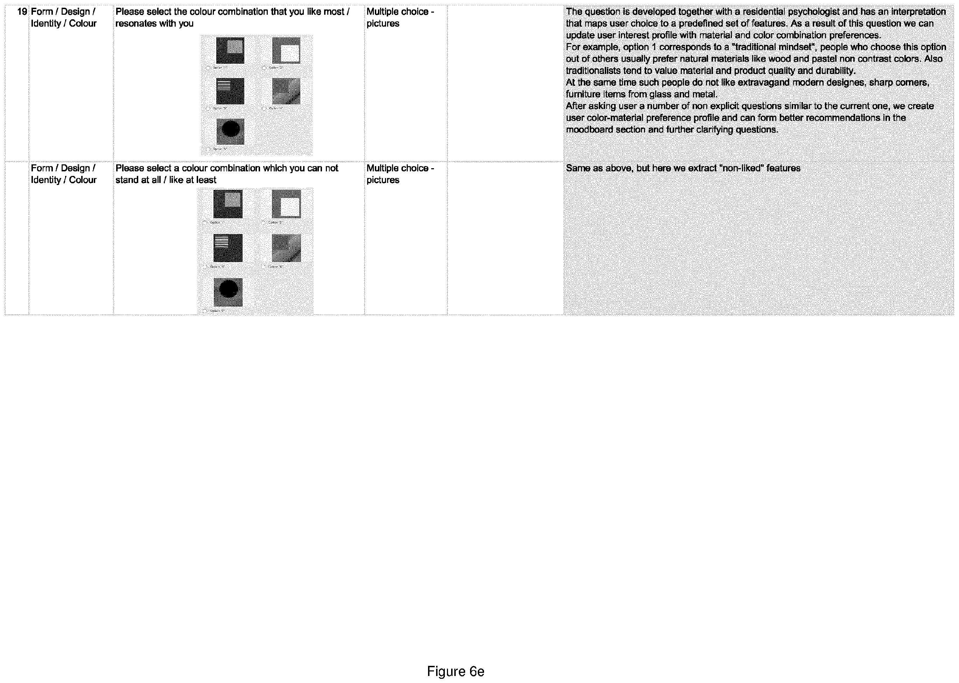

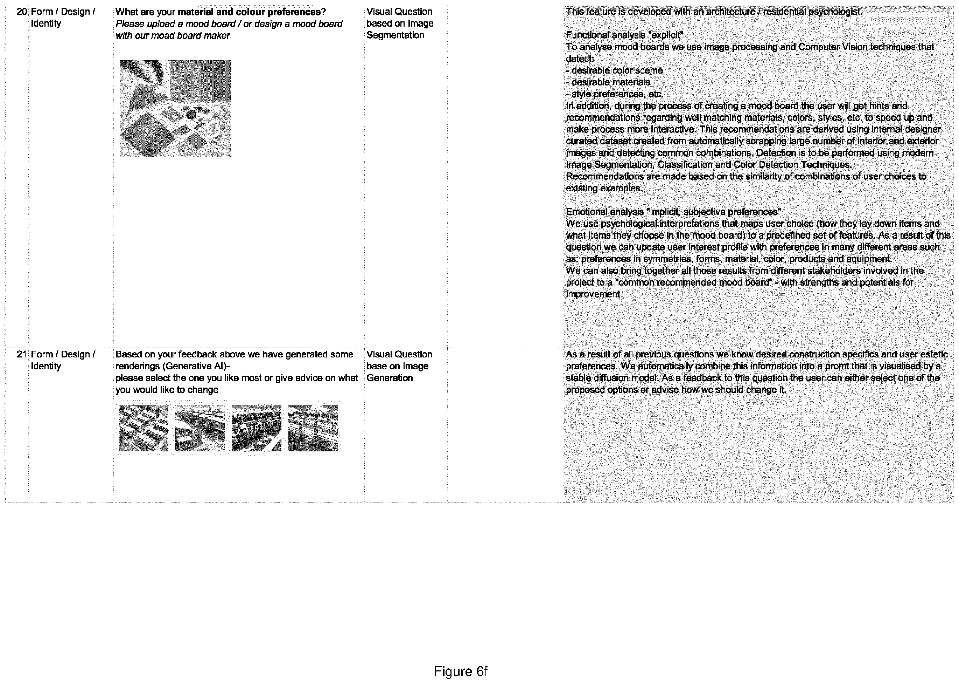

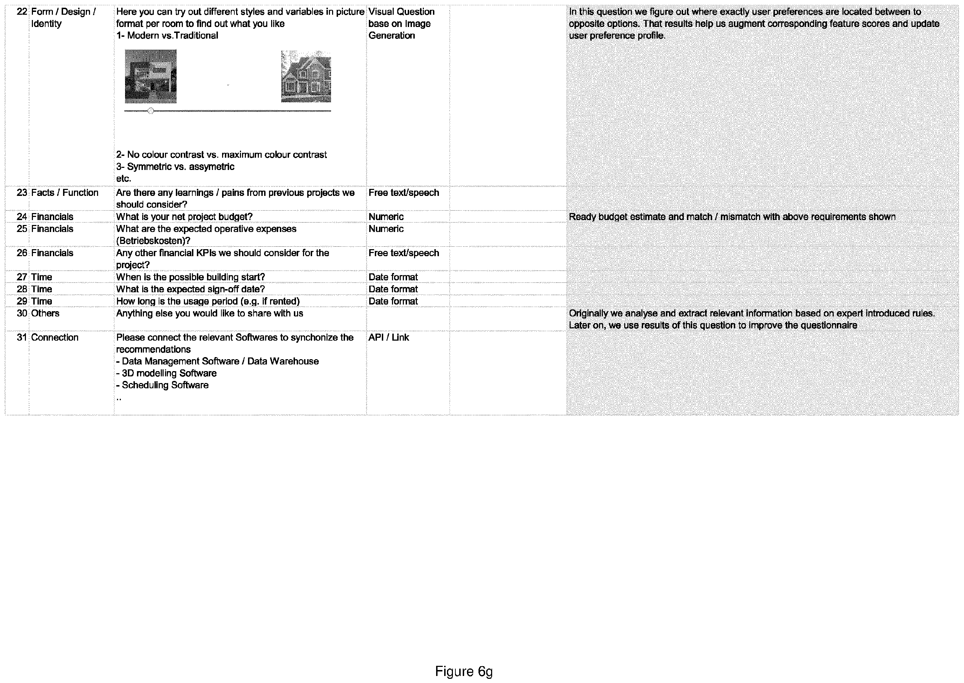

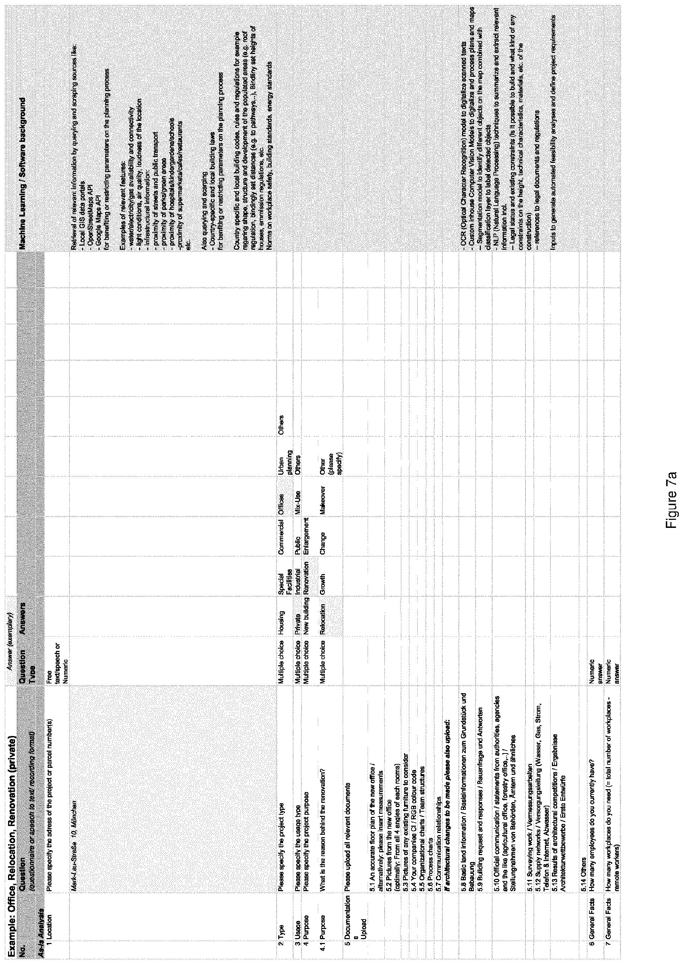

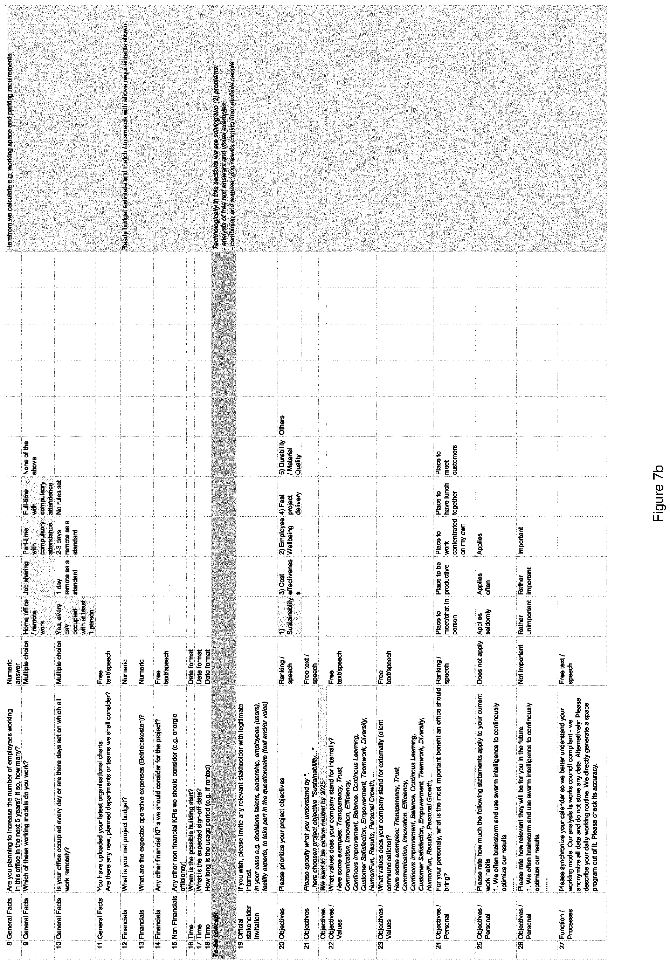

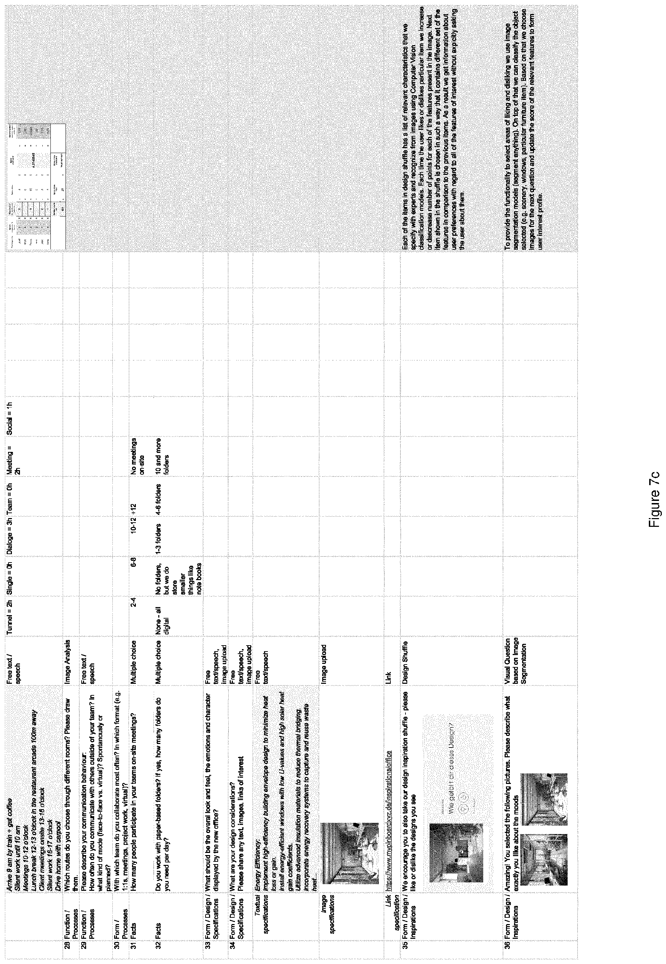

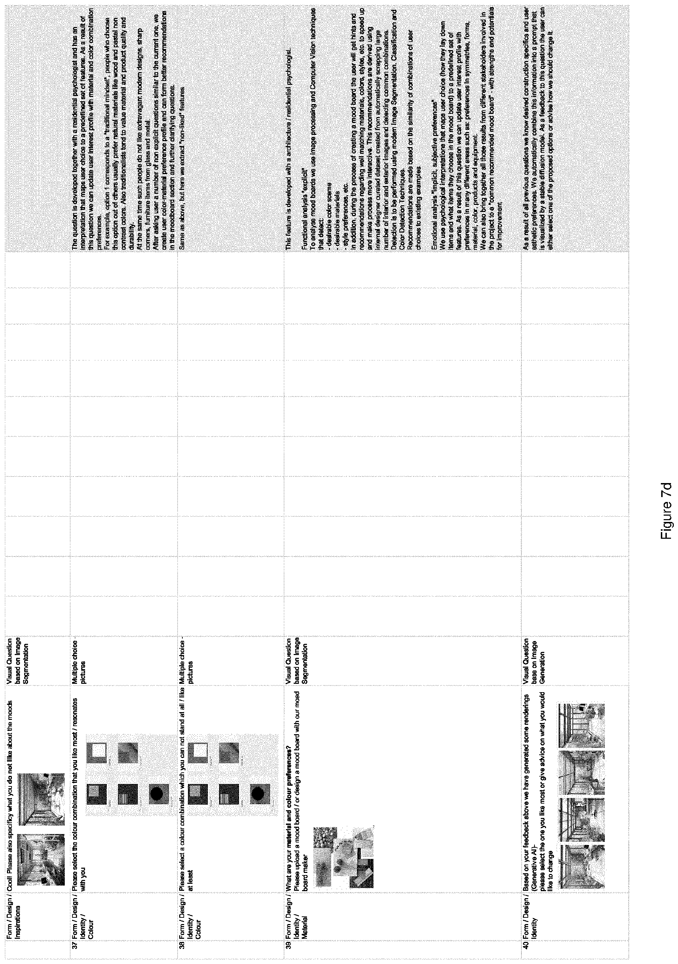

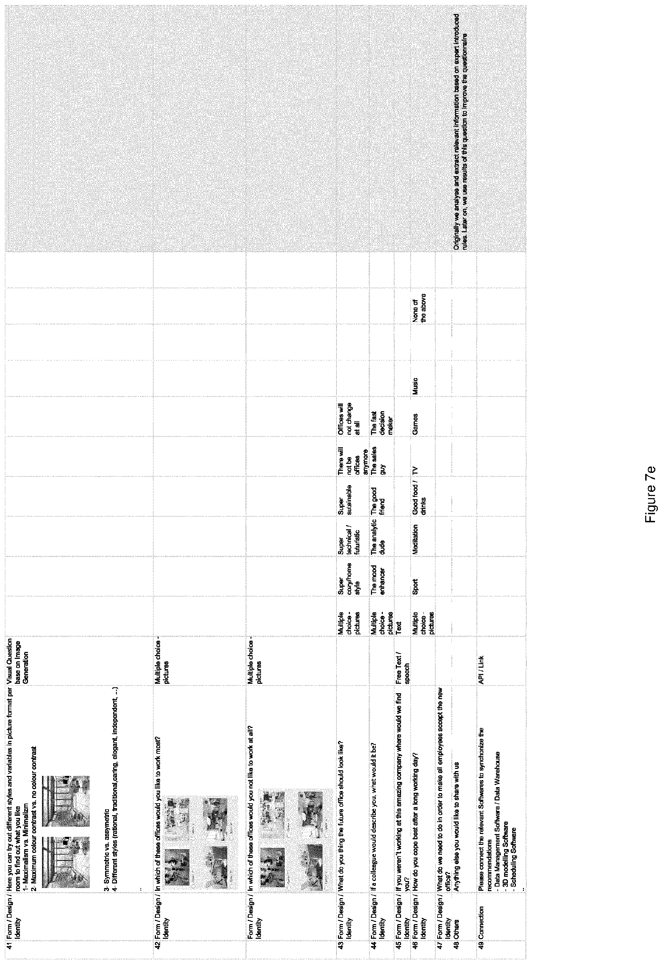

[Fig.5] shows meta data for the two exemplary embodiments of the invention presented in figures 6 and 7.
[Fig.6] a-g are the pages of a table describing an exemplary embodiment of the invention (private housing, new building / construction).
[Fig.7] a-e are the pages of a table describing another exemplary embodiment of the invention (office building, renovation).

### Description of Embodiments

At first, using special data sets to train/fine-tune computer vision and natural language processing models, a number of intelligent open-ended questionnaires is generated.

Each next question is defined by an algorithm based on expert knowledge and the customer's previous answers, generates hundreds of individual features from product images and descriptions to derive recommendations for new or complementary recommendations for new or existing buildings and interiors of clients.

### 1. Intelligent (Al-based) questionnaires

The client is provided with intelligent questionnaires that combine a mixture of text and image questions (objective and subjective answers).

From each question the algorithm learns more about the principles and its stakeholder requirements and suggests suitable follow-up questions.

There is a set of base questions created with experts in architecture and professional planners. In addition, there is a generative language model fine-tuned with internal data that generates additional questions based on previous answers.

From the feedback of the user(s) of the design process (= all involved in the design process), the algorithm automatically determines the most relevant construction, design, layout, material and equipment/interior options.

The algorithm generally makes a distinction between objective answers and subjective answers.

Objective answers are e.g. the number of working places needed, the specific fire regulations, the company's corporate identity, etc.

Subjective answers are e.g. personal positive or negative feelings caused by different architectural styles and designs, space and lightning situations, the ability to cope with color contrasts, preferences regarding symmetries, shapes, materials, colors and others.

Natural language processing techniques may be used in the requirements analysis, consisting of an open-ended questionnaire, a natural language processing pipeline to analyze the answers and to guide architects through the results.

By using natural language processing techniques, the meaning of the text answers provided by the client can be understood, relevant information be extracted, and new questions and answers be generated.

Natural language processing techniques may further be used to analyze the existing questions and responses from the experts, and to select or generate new questions as needed.

Further, knowledge graphs may be applied to represent the building industry domain and the relationships between different requirements, regulations, and stakeholders. By using a knowledge graph, the system can infer additional questions and insights from the available data.

Upload images: The customer can actively share images of living spaces with us (e.g. own photos or images from the web), interior design or color and material selection which are analyzed by the algorithm.

For individual households, the customer can also share social media profiles (e.g. a pin board) with us.

Upload documents: the customer can also upload relevant documentation, such as floor plans, regulations, official papers, etc.

In special embodiments of the invention, computer vision algorithms may be applied to analyze pictures and floor plans provided by customers to identify specific features, such as the number and location of rooms, the size of windows, or the presence of specific materials.

In special embodiments of the invention, natural language processing techniques may also be used to analyze the text descriptions that accompany pictures and floor plans, and/or natural language processing may be used to extract keywords and phrases that are relevant to the building industry.

This helps understand the customer's requirements and preferences more clearly.

### 2. Intelligent Mood Boards

The customer can also create a mood board or upload a board to be integrated as a requirement as part of the assessment.

In special embodiments of the invention, computer vision techniques are used to extract relevant features from images, such as shapes, colors, and textures and provide suitable recommendations of building objects, materials, and equipment.

### 3. Automatically generated building and room usage plan(s)

In special embodiments of the invention, and using information extracted from user uploads and questionnaire answers with help of modern deep learning algorithms, a draft of room usage plans may be generated, which subsequently can be edited by the user. This draft consists of text descriptions, data tables and graphic illustrations in a format that can be easily integrated with the common planning and design software(s).

### 4. Automatically derived artificial intelligence-based planning recommendations

Based on the knowledge from 1)-3) above, recommendations are provided automatically in 2D/3D modeling software and/or databases. As a result, the algorithm sorts out the right building elements, layouts, materials or equipment to be recommended to the user.

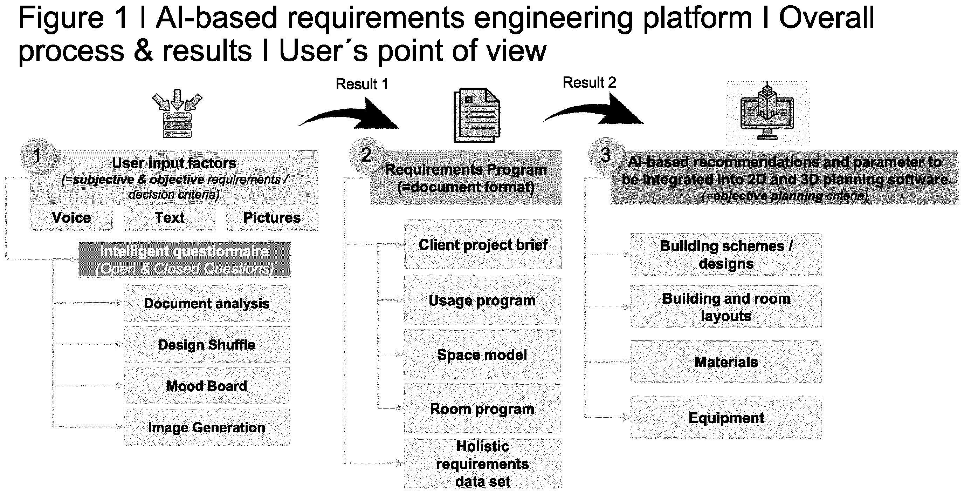

Fig. 1, with title, " Figure 1 I Al-based requirements engineering platform I Overall process & results I User's point of view ", shows an overview of the invention in an exemplary and non-restrictive manner.

In this example, the software and/or supporting company is called "Palasts" at least once. This naming shall also not be considered as restricting.

The table shows three columns.

Column 1 (left) specifies user input factors (=subjective and objective requirements / decision criteria) which may be for example in form of voice recordings, text or pictures. To be more specific: the system may pose questions in any form like voice recordings, text or pictures, and/or users answers may be given in any form like voice recordings, text or pictures as well. Further, the software may use combinations of these forms of questions and/or allow the user to answer in various ways combining them.

In detail, an Intelligent questionnaire, using open & closed questions, is presented to the user. Examples of various forms of the questions posed are "Document analysis", "Design Shuffle(s)" , "Mood Board(s)" and "Image Generation", which will become more clear in the descriptions of specific embodiments later on. This selection shall not be considered as limiting though: other forms of questions may be used in a similar way.

Column 2 (middle) specifies the "Requirements Program" in document format comprising "Client project brief", "Usage program", "Space model", "Room program", "Holistic requirements data set". Again, this selection shall not be considered as limiting: other forms of questions and/or documents may be used in a similar way. The result of the Requirements Program, called "Result 1", may include answers to the user input factors and/or intelligent questionnaire of Column 1 or any kind of information related to them. On the other hand, Result 1 may in itself be used as a result in the subsequent steps.

Column 3 (right) comprises Al-based recommendations and parameter to be integrated into 2D and 3D planning software as objective planning criteria. Again, "Building schemes / designs", "Building and room layouts", "Materials" and "Equipment" are examples and may be supplemented or modified.

In a similar way, the result of column 3, called "Result 2", may include user input obtained in the various subsections of Column 2, or any kind of information related to them. Further, result 2 may in itself be used as a result in the subsequent steps again.

The intended final results may be a 2D/3D model of the building including the extracted detailed building data sets and suitable planning recommendations.

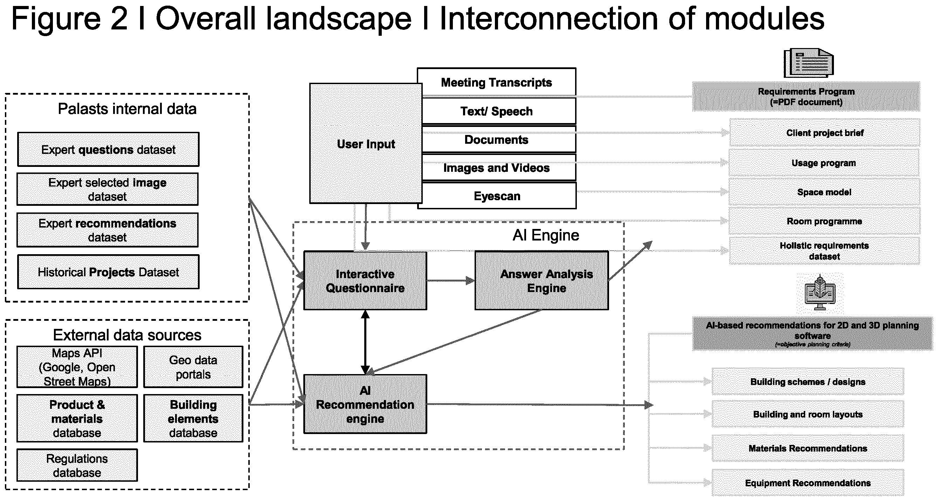

Figure 2, with title " Figure 2a I Overall landscape I Interconnection of modules", shows the interconnections of various modules in an embodiment of the invention.

"Palasts internal data" and "External data sources" as well as "User Input", each of them comprising various exemplary data sources, are input data to the inventive "Al Engine", which in itself comprises one or more "Interactive Questionnaire(s)" and/or "Al recommendation engine(s)" and/or "Answer Analysis Engine(s)" interacting with each other, as indicated by arrows.

"Palasts" is an exemplary name for the inventive software platform. The name in itself shall not be considered as limiting.

This selection of modules in itself shall not be considered as restrictive. The Al Engine might comprise further modules. Further, not all three modules shown need to be present or need to be active at all times.

As described before, the Al Engine submits results to the "Requirements Program" and/or "Al-based recommendations for 2D and 3D planning software" shown to the right of the diagram and/or interacts with them in any more elaborate form (e.g. repeated interactions or the like).

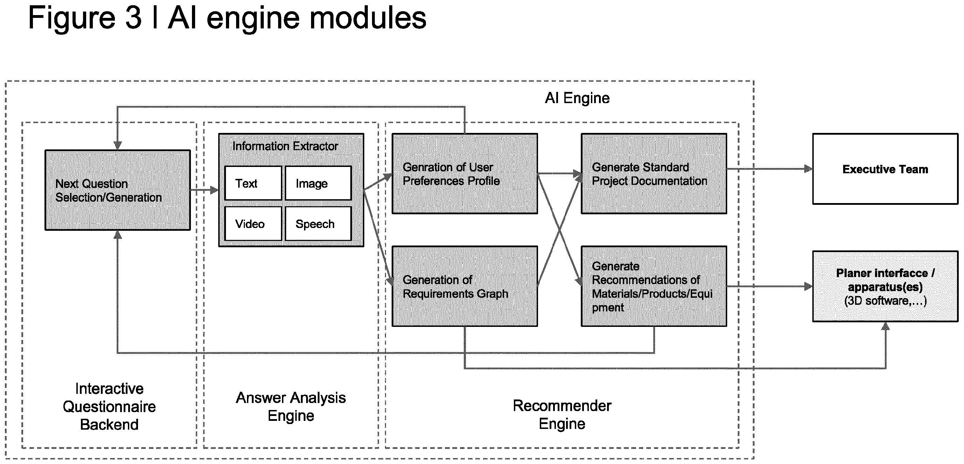

Figure 3, with title "Figure 3 I Al engine modules", shows a possible substructure of the Al Engine as well as its interfaces for user and stakeholder interaction in an exemplary way (there might be other modules as well as other connections included/omitted).

An "Interactive Questionnaire Backend" selects and/or generates questions to be posed to the user. These questions may be posed on some predefined order and/or may be selected according to user answers to earlier questions or user preferences determined earlier.

An "Answer Analysis Engine" analyses user answers and extracts relevant information in an " Information Extractor", which may for example be in forms of text and/or images and/or video and/or speech and/or any similar form of information transfer media or information transfer mode.

In the "Recommender Engine" an exemplary selection of modules is shown comprising "Generation of User Preferences Profile" and/or "Generation of Requirements Graph" and/or "Generating Standard Project Documentation" and/or "Generate Recommendations of Materials/Products/Equipment". Again, this selection in itself shall not be considered as limiting. Other modules may be applied as well and modules may interact in various different ways.

As shown to the right of the diagram, the Al engine gives output to the Executive Team and/or provides further Planer interface(s) / apparatus(es) like 3D software or the like. Other forms of output or interaction with other software(s) might also be provided as needed.

As shown to the left in figure 4a, a Registration for payment process may include steps of entering personal information, assigning/creating a project, enabling subscriber(s) to modify data, authenticate payment method. Then the recommendation flow is continued. This is registration for payment. There may also be a free accessible version available.

As shown in the middle of figure 4a, a questionnaire process with multiple people might start by inviting relevant stakeholders to the project (or part of it). In the next step, users conduct various questionnaires including speech, text questions and/or image questions. Subsequently, objective and intuitive criteria are translated into objective criteria for extracting recommendations to initiate a recommendation flow to a requirements program (document formats - e.g. word, pdf, excel) and/or recommendations are directly submitted into 2D/3D modeling software.

As shown to the right in figure 4a, when started, the building/room program first creates a space and/or room program. During subsequent steps, the space and/or room program may be changed or edited and the updated program will be saved.

To the left in figure 4b, a "Planer / Architect or User Feedback loop" is described comprising for example steps "Start", "Review recommendations", "Accept, select or change/edit recommendations", "Save 2D/3D model or building/room program", "Continue".

A flow chart of an (optional) eye scan is shown to the right of figure 4b. After starting the device, a selected image from the AI is shown and iris scan/recognition is conducted. Subsequently, patterns from the iris scan are read to find out how a users reacts to a certain result (positive, negative, neutral). On this basis, recommendations are refined and the recommendation flow is continued.

Figure 4c gives an overview of Al-generated results in the "Requirements Program" as described earlier.

Figure 4d gives an overview of Al-generated results in the "Al-based recommendations in 2D and 3D planning software" as described earlier.

Figure 4e shows exemplary details for question No 27 (here: new building) as an example for further and more detailed Al-generated results.

As exemplary embodiments of the invention, figures 6a-6g and 7a-7e show tables of typical questionnaires presented to the user of the system depending on the type of planed building. Figure 6a-6g show a typical questionnaire for a new private housing building, figures 7a-7e show a typical questionnaire for an office renovation project.

Figure 5 includes categories and sub-categories used in both tables as meta data. These tables further include some exemplary first answers of the user as well as some hints on how the inventive software system analyses these answers and further guides the user to obtain all necessary input from him and give proper recommendations in return. It should be noted that neither the form of these tables nor any specific information included or omitted in these tables shall be considered as limiting the scope of the invention. The specific questions contained in these tables are given by way of example only. Furthermore, the questions may vary widely in form (e.g. multiple choice vs. text vs. free speech vs. images, etc.), since the software system is capable of giving the user considerable freedom in the way he enters his information.

Figures 6a-6g show a table of a typical questionnaire for a planned private housing building.

The table comprises the columns
"No."
"Question *(questionnaire or speech to text*/*recording format)"*
"Question Type"
"Answers"
"Machine Learning / Software background"

As-is Analysis (No. 1, "location"):
Question: "Please specify the address of the project or parcel number(s)"
Type of Question: Free text/speech or Numeric
Answer: the user enters the street address.

The Machine Learning / Software background of this question is retrieval of relevant information by querying and scraping sources like: Local GIS data portals, OpenStreetMaps API, Google Maps API for parameters that either support or restrict the planning process. Examples of relevant features are:
- water/electricity/gas availability and connectivity
- light conditions, air quality, loudness of the location
- Infrastructural information:
- proximity of streets and public transport
- proximity of parks/green areas
- proximity of hospitals/kindergartens/schools
- proximity of supermarkets/cafes/restaurants
   etc.

Also querying and scraping:
- Country-specific and local building laws for parameters that either support or restrict the design and planning process

Country specific and local building codes, rules and regulations for example regarding shape, structure and development of the populated areas (e.g. roof regulation, obligatorily set distances (e.g. to pathways,..), obligatorily set heights of houses, emission regulations, etc."

### As-Is Analysis (No. 2.1, "Purpose"):

| | |
|---|---|
| Question: | "Please specify the project type" |
| Type of Question: | Multiple choice between the options "New building", "Renovation" or "Enlargement" |
| Answer: | In this example, the user selected "New building" |

### As-Is Analysis (No. 2, "Purpose"):

| | |
|---|---|
| Question: | "Please specify the project vertical" |
| Type of Question: | Multiple choice between the options "Housing", "Special Facilities", "Commercial", "Offices", "Urban planning", "Others" |
| Answer: | In this example, the user selected "Housing" |

### As-Is Analysis (No. 3, "Type"):

| | |
|---|---|
| Question: | "Please specify the detailed type of project vertical" |
| Type of Question: | Multiple choice between the options "Single-family house", "Multi-family house", "Row house", "Apartment building", "Cooperative housing", "Social housing", "Student dormitory", "Senior housing", "Loft apartments", |

### "Others (please specify)"

| | |
|---|---|
| Answer: | In this example, the user selected "Apartment building" |

### As-Is Analysis (No .4, "Usage"):

| | |
|---|---|
| Question: | "Please specify the usage type" |
| Type of Question: | Multiple choice between the options "Private", "Industrial", "Public", "Mix-Use", "Others" |
| Answer: | In this example, the user selected "Private" |

### As-Is Analysis (No. 5, "Documentations Upload")

| | |
|---|---|
| Question: | "Please upload all relevant documents" |
| Type of Question: | not specified |

Examples of relevant documentations to be uploaded by the user are:
5.1 Basic land information
5.2 Preliminary building application and responses
5.3 Building request and responses
5.4 Official communication / statements from authorities, agencies and the like (building office, agricultural office, forestry office,..)
5.5 Geological surveys
5.6 Surveying work
5.7 Utility lines (water, gas, electricity, telephone & internet, sewage, ...)
5.8 Results of architectural competitions
5.9 Others

The Machine Learning / Software background of this question is:
- OCR (Optical Character Recognition) model to digitize scanned texts
- Custom in-house Computer Vision Models to digitize and process plans and maps
- Segmentation model to identify different objects on the map combined with classification layer to label detected objects
- NLP (Natural Language Processing) techniques to summarize and extract relevant information incl.
- Legal status and existing constraints (is it possible to build and what kind of building, any constraints on the height, technical characteristics, materials, etc. of the construction)
- references to legal documents and regulations
- inputs to generate automated feasibility analyses and define project requirements

### As-Is Analysis (No. 6, "Background"):

Question: "Why has this location been selected?"
Type of Question: "Free text/speech"
Answer: In this special example, the user answered to the question entering the following text:
   "Housing for 200+ families required in the district.

The location has been found suitable to host up to 20 families.
Accessible public transport, kindergartens, schools and green leisure areas"

The Machine Learning/Software background of this question is to analyze results coming from free text questions using custom Natural Language Processing models that retrieve different types of information from the text, e.g. if there was sufficient research made regarding the location, if there are alternatives available etc.

### As-Is Analysis (No. 7, "Background"):

| | |
|---|---|
| Question: | "Have you considered any alternatives? If so, which?" |
| Type of Question: | Free text / speech |

Answer: In this special example, the user answered entering the following text:
"Yes, no other alternatives found with similar accessible benefits for families."

### Section "To-be concept"

In this section, the following two problems are solved:
- analysis of free text answers and visual examples
- combining and summarizing results coming from multiple people

To-be concept (No. 8, "Official stakeholder invitation"):
Question: "If you wish, please invite any relevant stakeholder with legitimate interest. In your case (private apartment buildings), you can invite e.g. investors, facility experts, owners and/or users to take part in the questionnaire"
Type of Question: text and/or voice

### To-be concept (No. 9, "Objectives"):

| | | |
|---|---|---|
| Question : | "Please prioritize your project objectives" | |
| Type of Question: | Ranking / text / speech: | |
| Answer: | In this special example the customer might prioritize as follows: | |
| "3) Sustainability | 1) Cost effectiveness | 2) Residential Wellbeing |
| 4) Fast project delivery | 5) Durability / Material Quality | Others" |

Although "Cost effectiveness" will get the highest priority, also the remaining options are ranked: "Residential Wellbeing" is of second priority, "Sustainability" is of third priority etc.

To-be concept (No. 10, "Objectives"):

| | |
|---|---|
| Question : | "Please specify what you understand by " followed by the chosen project objective, e.g. "Cost effectiveness..." |
| Type of Question: | Free text/speec |

h

This is a typical example on how the system crafts additional new questions based on the answers already received beforehand by the user in order to clarify necessary details.

In this special case, the user might for example answer:
"Not more than 11 EUR per square meter"
to clarify his personal preference as of what is to be considered as cost effective.

To-be concept (No. 11, "Function/Facts"):
Question: "How many apartments do you need?"

In this special case, the user might for example answer:
"20 apartments for different income groups"

To-be concept (No. 12, "Function/Facts"):
Question: "How many rooms per apartment and what kind of rooms are needed?"
Answer 1: The user might answer in text format, e.g.:
   "Each apartment with a minimum of 1 bath, 1 kitchen, 1 guest toilet, 2-3 bedrooms, 1 open living and dining room, washing and household room"
Answer 2: On the other hand, the user might for example answer in table format, like indicated, entering a table containing columns "No.", "Type of room", "Number of rooms", "Size", "m² in total", "Location", "Usage".

For this special example, the data for only one room is entered, but it should be clear that this table will probably contain data for all or most of the rooms of the building and that this information might be collected from various stakeholders to generate a common calculation.

The Machine Learning/Software background of this question is as follows:
In order to generate optimal floor plans, in an embodiment of the invention, the system will first analyze user requirements provided in text form using a combination of NLP techniques, predefined expert rules and construction site information defined in all previous questions.

Such information is then represented in form of adjacency graphs.

Afterwards, the system will solve an optimization problem to obtain one or more (probably many) possible graph-based representations of potential floor layouts.

The results can then be used either directly or as a partial template for further optimization after the user has indicated which parts need to be changed.

A final layout can then either be represented graphically or in a tabular form.

To-be concept (No. 13, "Function/Usage"):
Question: "Which rooms are especially important for your users or for you? Why? (Consider: Where do you spend most time?)"
In this special case, the user might for example answer: "Living room, dining room"

To-be concept (No. 14, "Function/Usage"):
Question: "Per invited user: Please describe your daily routine. How do you structure your operational processes? Which routes do you choose through different rooms? "

In this special case, the user might for example answer:
"Get up, shower, get dressed, wake up kids, dress kids, prepare breakfast, pack breakfast, ...."

To-be concept (No. 15, "Form/Design/Specifications"):
Question: "What are your design considerations? Please share any text, images, links of interest" The user may answer using free text/speech or image upload.

To answer this question, the user then might for example enter further textual specifications (which is his own choice, as indicated), like:
"The residential building should be designed with a modern and attractive aesthetic, blending with the surrounding environment. The building should be multi-story and spacious, with each family having their private living space, including bedrooms, living room, kitchen, and bathrooms. The design should provide enough natural light and ventilation for each unit..."

Further, in order to (quasi indirectly) answer this question, the user might also upload images that are subsequently analyzed by the software to extract any relevant information in the given context of the question.

In addition, the user then might include a link specification containing a link to some specific website or data source of any kind.

This example shows that the answers to the question might be given in a variety of different forms: multiple choice lists, text input, speech, images uploaded, etc. Each of these possibilities might have certain advantages and/or disadvantages for the user. Furthermore, the system might also retrieve additional information regarding the way the user answers the question.

For example, if the user prefers to upload images and avoids answering questions in text form, he might be more inclined to work visually and this preference might be of influence on how additional or subsequent questions are carved and presented to the user. On the other hand, as pointed out before, such features shall not be considered as limiting to the scope of the invention.

To-be concept (No. 16, "Form/Design/Inspirations"):
Question: "We encourage you to also take our design inspiration shuffle - please like or dislike the designs you see"
The user is then inspired to explain his opinion on the presented design photo.

### Type of Question: Design Shuffle

The Machine Learning/Software background of this question is as follows:
Each of the items in design shuffle has a list of relevant characteristics that we specify with experts and recognize from images using Computer Vision classification models. Each time the user likes or dislikes a particular item, we increase or decrease a number of points for each of the features present in the image. The next item shown in the shuffle is chosen in such a way that it contains different set of the features in comparison to the previous items. As a result we get information about user preferences with regard to all of the features of interest without explicitly asking the user about them.

To-be concept (No. 17, "Form/Design/Inspirations"):
Question: "Amazing! You selected the following pictures. Please describe what exactly you like about the moods"
Type of Question: Visual Question based on Image Segmentation
The software is able to present a Visual Question based on Image Segmentation to the user.

To provide the functionality to select areas of liking and disliking we use image segmentation models (segment anything). On top of that we can classify the object selected (e.g. scenery, windows, particular furniture item). Based on that we choose images for the next question and update the score of the relevant features to form user interest profile.

To-be concept (No. 18, "Form/Design/Inspirations"):
Question: "Cool! Please also specify what you do not like about the moods" The user is then presented a selection of images.
Type of Question: Visual Question based on Image Segmentation

To-be concept (No. 19, "Form/Design/ldentity/Color"):
Question: "Please select the color combination that you like most/resonates with you"
Type of Question: Multiple choice - pictures

The question is developed together with a residential psychologist and has an interpretation that maps user choice to a predefined set of features. As a result of this question, we can update user interest profile with material and color combination preferences. For example, option 1 corresponds to a "traditional mindset", people who choose this option out of others usually prefer natural materials like wood and pastel non contrast colors. Also, traditionalists tend to value material and product quality and durability. At the same time such people do not like extravagant modern designs, sharp corners, furniture items from glass and metal. After asking user a number of non-explicit questions similar to the current one, we create user color-material preference profile and can form better recommendations in the mood board section and further clarifying questions.
Question: "Please select the color combination which you can not stand at all / like at least"
Type of Question: Multiple choice - pictures
Machine learning background: same as above, but here we extract "non-liked" features.

To-be concept (No. 20, "Form/Design/ldentity/Color"):
Question: "What are your material and color preferences?"
Please upload a mood board/or design a mood board with our mood board maker"
Type of Question: Visual Question based on Image Segmentation

The Machine Learning / Software background of this question is as follows:
This feature is developed with an architecture / residential psychologist.

### (1) Functional analysis "explicit":

To analyze mood boards, we use image processing and Computer Vision techniques that detect:
- desirable color scheme
- desirable materials
- style preferences, etc.

In addition, during the process of creating a mood board the user will get hints and recommendations regarding well matching materials, colors, styles, etc. to speed up and make process more interactive. These recommendations are derived using internal designer curated dataset created from automatically scrapping large number of interior and exterior images and detecting common combinations. Detection is to be performed using modern Image Segmentation, Classification and Color Detection Techniques. Recommendations are made based on the similarity of combinations of user choices to existing examples.

### (2) Emotional analysis "implicit, subjective preferences":

We use psychological interpretations that maps user choice (how they lay down items and what items they choose in the mood board) to a predefined set of features. As a result of this question we can update user interest profile with preferences in many different areas such as: preferences in symmetries, forms, material, color, products and equipment. We can also bring together all those results from different stakeholders involved in the project to a "common recommended mood board" - with strengths and potentials for improvement.

To-be concept (No. 21, "Form/Design/Identity"):
Question: "Based on your feedback above, we have generated some renderings (Generative Al) - please select the one you like most or give advice on what you would like to change"
Type of Question: Visual Question base on Image Generation

The Machine Learning/Software background of this question is as follows:
As a result of all previous questions we know desired construction specifics and user aesthetic preferences. We automatically combine this information into a prompt that is visualized by a stable diffusion model. As a feedback to this question, the user can either select one of the proposed options or advise how we should change it.

To-be concept (No. 22, "Form/Design/Identity"):
Question: "Here you can try out different styles and variables in picture format per room to find out what you like"
   1- Modern vs. Traditional
   2- No color contrast vs. maximum color contrast
   3- Symmetric vs. asymmetric
      etc.
Type of question: Visual Question based on Image Generation

The Machine Learning/Software background of this question is as follows:
In analyzing the users answer to this question, the invention figures out where exactly user preferences are located between to opposite options. These results help us augment corresponding feature scores and update the user preference profile.

To-be concept (No. 23, "Facts/Function"):
Question: "Are there any learnings / pains from previous projects we should consider?"
Type of question: "Free text/speech"

To-be concept (No. 24, "Financials"):
Question: "What is your net project budget?"
Type of question: Numeric

The Machine Learning/Software background of this question is as follows:
Ready budget estimate and match/mismatch with above shown

To-be concept (No. 25, "Financials"):
Question: "What are the expected operative expenses?"
Type of question: Numeric

To-be concept (No. 26, "Financials"):
Question: "Any other financial KPIs we should consider for the project?"
Type of question: Free text/speech

To-be concept (No. 27, "Time"):
Question: "When is the possible building start?"
Type of question: Date format

To-be concept (No. 28, "Time"):
Question: "What is the expected sign-off date?"
Type of question: Date format

To-be concept (No. 29, "Time"):
Question: "How long is the usage period (e.g. if rented)?"
Type of question: Date format

To-be concept (No. 30, "Others"):
Question: "Anything else you would like to share with us?"

The Machine Learning/Software background of this question is as follows:
Originally, we analyze and extract relevant information based on expert introduced rules. Later on, we use results of this question to improve the questionnaire.

To-be concept (No. 31, "Connection"):
Question:
   "Please connect the relevant softwares to synchronize the recommendations
   - Data Management Software/Data Warehouse
   - 3D modeling Software
   - Scheduling Software
Others
   Type of question: API/Link

Figure 7a-7e show a table of a typical questionnaire for a planned private office building.

The table comprises the columns
"No."
"Question *(questionnaire or speech to text*/*recording format)"*
"Question Type"
"Answers"
"Machine Learning/Software background"

Although these are the same columns as in the table of figure 6, this shall by no means be seen as a limitation: the form of the table and the selection of columns may vary of course.

As-Is Analysis (No. 1, "location"):
Question: "Please specify the address of the project or parcel number(s) "
Type of question: Free text/speech or Numeric
Answer (in this example): "Mark-Lau-Straße 10, München "

The Machine Learning/Software background of this question is:
Retrieval of relevant information by querying and scraping sources like:
- Local GIS data portals
- OpenStreetMaps API
- Google Maps API
for benefiting or restricting parameters on the planning process

Examples of relevant features:
- water/electricity/gas availability and connectivity
- light conditions, air quality, loudness of the location
- Infrastructural information:
- proximity of streets and public transport
- proximity of parks/green areas
- proximity of hospitals/kinder gardens/schools
- proximity of supermarkets/cafes/restaurants
etc.

Also querying and scarping
- Country-specific and local building laws
for benefiting or restricting parameters on the planning process

Country specific and local building codes, rules and regulations for example regarding shape, structure and development of the populated areas (e.g. roof regulation, bindingly set distances (e.g. to pathways,..), Binding set heights of houses, emission regulations, etc.

### Norms on workplace safety, building standards, energy standards

As-is Analysis (No. 2, "Type: Please specify the project type"):
Question: "Please specify the project type"
Type of question: Multiple choice
Choices: "Housing", "Special Facilities", "Commercial", "Offices", "Urban planning", "Others"
Answer: In this example, the user selected "Office".

As-Is Analysis (No. 3, "Usage"):

| | |
|---|---|
| Question: | "Please specify the usage type" |
| Type of question: | "Multiple choice" |
| Choices: | "Private", "Industrial", "Public", "Mix-Use", "Others" |
| Answer: | In this example, the user selected "Private". |

As-Is Analysis (No. 4, "Purpose"):
Question: Please specify the project purpose
Type of question: Multiple choice
Choices: "New building", "Renovation", "Enlargement"
Answer: In this example, the user selected "Renovation".

As-Is Analysis (No. 4.1, "Purpose"):
Question: "What is the reason behind the renovation?"
Type of question: Multiple choice
Choices: "Relocation", "Growth", "Change, "Makeover", "Other (please specify)"
Answer: In this example, the user selected "Relocation".

As-Is Analysis (No. 5, "Documentations Upload"):
Question: "Please upload all relevant documents"
5.1 An accurate floor plan of the new office /
   alternatively: please insert measurements
5.2 Pictures from the new office (optimally: From all 4 angles of each rooms)
5.3 Pictures of any existing furniture to consider
5.4 Your company's CI/RGB color code
5.5 Organizational charts/Team structures
5.6 Process charts
5.7 Communication relationships

If architectural changes to be made please also upload:
5.8 Basic land information
5.9 Building request and responses
5.10 Official communication / statements from authorities, agencies and the like (agricultural office, forestry office,..)
5.11 Surveying work
5.12 Supply networks (Water, Gas, Electricity, Telephone & Internet, wastewater)
5.13 Results of architectural competitions/First plans
5.14 Others

The Machine Learning/Software background of this question is:
- OCR (Optical Character Recognition) model to digitize scanned texts
- Custom inhouse Computer Vision Models to digitize and process plans and maps
- Segmentation model to identify different objects on the map combined with classification layer to label detected objects
- NLP (Natural Language Processing) techniques to summarize and extract relevant information incl.
- Legal status and existing constraints (is it possible to build and what kind of building, any constraints on the height, technical characteristics, materials, etc. of the construction)
- references to legal documents and regulations

### Inputs to generate automated feasibility analyses and define project requirements

To analyze results coming from free text questions, custom Natural Language Processing models are built, which retrieve different types of information from the text, e.g. if there was sufficient research made regarding the location, if there are alternatives available
As-is Analysis (No. 6, "General Facts"):
   Question: "How many employees do you currently have?"
   Type of question: Numeric answer
As-is Analysis (No. 7, "General Facts"):
   Question: "How many workplaces do you need (=total number of workplaces - remote workers)"
Type of question: Numeric answer
As-is Analysis (No. 8, "General Facts"):
   Question: "Are you planning to increase the number of employees working
   in this office in the next 5 years? If so, how many?"
Type of question: Numeric answer

From these numbers e.g. we calculate the working space needed and parking requirements.

As-Is Analysis (No. 9, "General facts"):
Question: "With which of these working models do you work?"
Type of question: Multiple choice
Choices: "Home office / remote work", "Job sharing", "Part-time with compulsory attendance", "Full-time with compulsory attendance", "None of the above"

As-Is Analysis (No. 10, "General Facts"):
Question: "Is your office occupied every day or are there days set on which all employees work remotely?"
Type of question: Multiple choice
Choices: "Yes, every day occupied with at least 1 person", "1 day remote as a standard", "2-3 days remote as s standard", "No rules set"

As-Is Analysis (No.11, "General Facts"):
Question: "You have uploaded your latest organizational charts.
Are there any new, planned departments or teams we shall consider?"
Type of question: Free Text / speech

As-Is Analysis (No. 12, "Financials"):
Question: "What is your net project budget?"
Type of question: Numeric

The Machine Learning/Software background of this question is as follows:
Ready budget estimate and match/mismatch with above shown

As-Is Analysis (No.13, "Financials"):
Question: "What are the expected operative expenses?"
Type of question: Numeric

As-Is Analysis (No. 14, "Financials"):
Question: "Any other financial KPI's we should consider for the project?"
Type of question: Free text/speech

As-Is Analysis (No. 15, "Non-Financials"):
Question:
"Any other non-financial KPI's we should consider (e.g. energy efficiency)?"

As-Is Analysis (No. 16, "Time"):
Question: "When is the possible building start?"
Type of question: Date format

As-Is Analysis (No. 17, "Time"):
Question: "What is the expected sign-off date? "
Type of question: Date format

As-is Analysis (No. 18, "Time"):
Question: "How long is the usage period (e.g. if rented)?"
Type of question: Date format

**To-be concept:** Technologically in this sections we are solving two (2) problems:
- analysis of free text answers and visual examples
- combining and summarizing results coming from multiple people

To-be concept (No. 19, "Official stakeholder invitation"):
Question: "If you wish, please invite any relevant stakeholder with legitimate interest. In your case e.g. decisions takers, leadership, employees (users), facility experts, to take part in the questionnaire (text and/or voice)"

To-be concept (No. 20, "Objectives"):
Question: "Please prioritize your project objectives."
Type of question: Ranking/speech
Options: "1) Sustainability", "3) Cost effectiveness", "2) Employee Wellbeing",
"4) Fast project delivery", "5) Durability / Material Quality", "Others"
Answer: here the numbering represents the customers' preferred priorities already

To-be concept (No. 21): "Objectives"
Question: "Please specify what you understand by Sustainability"
   (referring to the prioritized option of the last question, by way of example).
Type of question: Free text/speech
Answer (as "Objectives"): "We want to be carbon neutral by 2025"

To-be concept (No. 22, "Objectives/Values"):
Question: "What values does your company stand for internally?
Some examples: "Transparency, Trust, Communication, Innovation, Efficiency, Continuous Improvement, Balance, Continuous Learning, Customer Satisfaction, Empowerment, Teamwork, Diversity, Humor/Fun, Results, Personal Growth, ..."
Type of question: Free text/speech

To-be concept (No. 23, "Objectives/Values"):
Question: "What values does your company stand for externally (client communications)?
Some examples: "Transparency, Trust, Communication, Innovation, Efficiency, Continuous Improvement, Balance, Continuous Learning, Customer Satisfaction, Empowerment, Teamwork, Diversity, Humor/Fun, Results, Personal Growth, ..."
Type of question: Free text/speech

To-be concept (No. 24, "Objectives/Personal"):
Question: "For you personally, what is the most important benefit an office should bring?"
Type of question: Ranking/speech
Options: "Place to meet/chat in person ", "Place to be productive",
"Place to work concentrated on my own ", "Place to have lunch together",
"Place to meet customers"

To-be concept (No. 25, "Objectives/Personal"):
Question:
   "Please rate how much the following statements apply to your current work habits:
   1. We often brainstorm and use swarm intelligence to continuously optimize our results (+ usually several further questions of similar kind)"
Type of question: Ranking/speech
Options: "Does not apply", "Rarely Applies", "Applies often", "Applies"

To-be concept (No. 26, "Objectives/Personal"):
Question:
   "Please rate how relevant they will be for you in the future."
   1. We often brainstorm and use swarm intelligence to continuously optimize our results" (+ usually several further questions of similar kind)
Type of question: Ranking/speech
Options: "Not important", "Rather unimportant", "Rather important", "Important"

To-be concept (No. 27, "Function/Processes"):
Question:
   "Please synchronize your calendar so we better understand your working mode. Our analysis is works council compliant - we make all data anonymous and do not store any data. Alternatively:
   Please describe your daily working routine. We directly generate a space program out of it. Please check its accuracy."
Type of question: Free text/speech
Answer:
   "Arrive 9 am by train, walk to the office
   Drink coffee
   Silent work until 10 am
   Meetings 10-12 o'clock
   Lunch break 12-13 o'clock in the restaurant arcade 100m away
   Client meetings by phone 13-16 o'clock
   Silent work 16-17 o'clock
   Drive home with carpool"
   Type of question: Free text / speech
Options:
   "Tunnel = 2h", "Single = 0h", "Dialogue = 3h", "Team = 0", "Meeting = 2h",
   "Social = 1h"

### The software analyzes this data in appropriate manner (see table for an example)

To-be concept (No. 28, "Function/Processes"):
Question: "Which routes do you choose through different rooms? Please draw them."
Type of question: "Image Analysis"

To-be concept (No .29, "Function/Processes"):
Question: "Please describe your communication behavior:
How often do you communicate with others outside of your team? In what kind of mode (face-to-face vs. virtual)? Spontaneously or planned?"
Type of question: Free text/speech

To-be concept (No.30, "Form/Processes"):
Question: "With which team do you collaborate most often? In which format (e.g. 1:1s, meetings, project work, virtual)?"

To-be concept (No. 31,"Facts"):
Question: "How many people participate in your team's on-site meetings?"
Type of question: Multiple choice
Options: "2-4","6-8","10-12","+12","No meetings on-site"

To-be concept (No. 32, "Facts"):
Question: "Do you work with paper-based folders? If yes, how many folders do you need per day?"
Type of question: Multiple choice
Options: "None - all digital", "No folders, but we do store smaller things like note books", "1-3 folders", "4-6 folders", "10 and more folders"

To-be concept (No. 33, "Form/Design/Specifications"):
Question: "What should be the overall look and feel, the emotions and character displayed by the new office?"
Type of question: Free text/speech, image upload

To-be concept (No. 34,"Form/Design/Specifications"):
Question:
"What are your design considerations? Please share any text, images, links of interest."
Type of question: Free text/speech, image upload

First exemplary customer answer (using textual specifications):
"Energy Efficiency: Implement high-efficiency building envelope design to minimize heat loss or gain.
Install energy-efficient windows with low U-values and high solar heat gain coefficients. Utilize advanced insulation materials to reduce thermal bridging.
Incorporate energy recovery systems to capture and reuse waste heat..."

Second exemplary customer answer (using image specifications, Image upload):
Images to be considered in the further analysis

Third exemplary customer answer (using Link specification)
Customer enters the following link (as an example):
https://www.mypinboardxyz.de/inspirations/office

To-be concept (No. 35, "Form/Design/Inspirations"):
Question: "We encourage you to also take our design inspiration shuffle -
   please like or dislike the designs you see"
Type of question: Design Shuffle
Machine Learning / Software background: Each of the items in design shuffle has a list of relevant characteristics that we specify with experts and recognize from images using Computer Vision classification models. Each time the user likes or dislikes particular item we increase or decrease number of points for each of the features present in the image. Next item shown in the shuffle is chosen in such a way that it contains different set of the features in comparison to the previous items. As a result we get information about user preferences with regard to all of the features of interest without explicitly asking the user about them.

To-be concept (No. 36, "Form/Design/Inspirations"):
Question:
   "Amazing! You selected the following pictures. Please describe what exactly you like about the moods"
   Type of question: Visual Question based on Image Segmentation
   Machine Learning / Software background: To provide the functionality to select areas of liking and disliking we use image segmentation models (segment anything). On top of that we can classify the object selected (e.g. scenery, windows, particular furniture item). Based on that we choose images for the next question and update the score of the relevant features to form user interest profile.
Question (Second question for same number):
   "Cool! Please also specify what you do not like about the moods"
   Type of question: Visual Question based on Image Segmentation
      (see logic above)

To-be concept (No. 37, "Form/Design/ldentity/Color"):
Question:
"Please select the color combination that you like most/resonates with you"
Type of question: Multiple choice - pictures
Machine Learning / Software background: The question is developed together with a residential psychologist and has an interpretation that maps user choice to a predefined set of features. As a result of this question we can update user interest profile with material and color combination preferences. For example, option 1 corresponds to a "traditional mindset", people who choose this option out of others usually prefer natural materials like wood and pastel non contrast colors. Also traditionalists tend to value material and product quality and durability. At the same time such people do not like extravagant modern designs, sharp corners, furniture items from glass and metal.

After asking user a number of non explicit questions similar to the current one, we create user color-material preference profile and can form better recommendations in the mood board section and further clarifying questions.

To-be concept (No. 38,"Form/Design/ldentity/Color"):
Question:
"Please select a color combination which you cannot stand at all/like the least"
Type of question: Multiple choice - pictures
Same as above, but here we extract "non-liked" features

To-be concept (No. 39, "Form/Design/ldentity/Material"):
Question:
"What are your material and color preferences? Please upload a mood board/or design a mood board with our mood board maker"
Type of question: "Visual Question based on Image Segmentation"
This feature is developed with a architecture / residential psychologist.

### Functional analysis "explicit"

To analyse mood boards we use image processing and Computer Vision techniques that detect:
- desirable color scheme
- desirable materials
- style preferences, etc.

In addition, during the process of creating a mood board the user will get hints and recommendations regarding well matching materials, colors, styles, etc. to speed up and make process more interactive. This recommendations are derived using internal designer curated dataset created from automatically scrapping large number of interior and exterior images and detecting common combinations. Detection is to be performed using modern Image Segmentation, Classification and Color Detection Techniques.

Recommendations are made based on the similarity of combinations of user choices to existing examples.

### Emotional analysis "implicit, subjective preferences"

We use psychological interpretations that maps user choice (how they lay down items and what items they choose in the mood board) to a predefined set of features. As a result of this question we can update user interest profile with preferences in many different areas such as: preferences in symmetries, forms, material, color, products and equipment.

We can also bring together all those results from different stakeholders involved in the project to a "common recommended mood board" - with strengths and potentials for improvement
To-be concept (No. 40, "Form/Design/Identity"):
Question:
"Based on your feedback above, we have generated some renderings (Generative Al) - please select the one you like most or give advice on what you would like to change"
Type of question: "Visual Question based on Image Generation"
Machine Learning / Software background: As a result of all previous questions we know desired construction specifics and user esthetic preferences. We automatically combine this information into a prompt that is visualized by a stable diffusion model. As a feedback to this question the user can either select one of the proposed options or advise how we should change it.

To-be concept (No. 41, "Form/Design/Identity"):
Question:
"Here you can try out different styles and variables in picture format per room to find out what you like
   1- Maximalism vs. Minimalism
   2- Maximum color contrast vs. no color contrast
   3- Symmetric vs. asymmetric
   4- Different styles (rational, traditional, caring, elegant, independent, etc.)..."
Type of question: Visual Question based on Image Generation

To-be concept (No. 42, "Form/Design/Identity"):
Question:
   "In which of these offices would you like to work most?"
   Type of question: Multiple choice - pictures
Second Question for same number ("Form / Design /Identity"):
   "In which of these offices would you not like to work at all?"
   Type of question: Multiple choice - pictures

To-be concept (No. 43, "Form/Design/Identity"):
Question: "What do you think the future office should look like? "
Type of question: Multiple choice - pictures
Choices: "Super cozy/home style", "Super technical/futuristic", "Super sustainable", "There will not be offices anymore", "Offices will not change at all"

To-be concept (No. 44, "Form/Design/Identity"):
Question: "If a colleague would describe you, what would it be?"
Type of question: Multiple choice - pictures
Choices: "The mood enhancer", "The analytic dude", "The good friend", "The sales guy", "The fast decision maker"

To-be concept (No. 45, "Form/Design/Identity"):
Question:
"If you were not working at this amazing company where would we find you?"
Type of question: Free Text/Speech

To-be concept (No. 46,"Form/Design/identity"):
Question:
"How do you cope best after a long working day?"
Type of question: Multiple choice - pictures
Choices: "Sport", "Meditation", "Good food/drinks", "TV", "Games", "Music", "None of the above"

To-be concept (No. 47, "Form/Design/Identity"):
Question:
"What do we need to do in order to make all employees accept the new office?"

To-be concept(No.48,"Others"):
Question: "Anything else you would like to share with us "

The Machine Learning / Software background of this question is:
Originally, we analyze and extract relevant information based on expert introduced rules. Later on, we use results of this question to improve the questionnaire.

To-be concept (No. 49, "Connection"):
Question:
"Please connect the relevant softwares to synchronize the recommendations - Data Management Software/Data Warehouse - 3D modeling Software - Scheduling Software."
Type of question: API/Link

It should be understood that the special selection of questions presented here, as well as the conclusions the AI draws from them, are simply examples, and may of course vary between various applications. Especially, the form of a question (text, image-based, audio, multiple choice, free speech etc.) shall not be considered as limiting. Further, the examples presented here shall not be considered as limiting: omitting certain questions in these examples, supplementing further questions to these examples, constructing similar examples by changing the type of questions posed etc. shall all not be considered as limiting to the scope of the invention as it is defined by the following claims.

## Claims

1. Computer-implemented method for generating automated planning and design recommendations for buildings, the method comprising
- implementing at least one computer vision model
- implementing at least one natural language processing model
- training the computer vision model(s) and/or language processing model(s) using special data sets
- preparing at least one questionnaire containing questions based on the trained computer vision model(s) and/or language processing model(s)
- presenting the questionnaire(s) to a user and recording his answers
- generate recommendations and/or additional questions to the user
based on the answers.

2. Method of Claim 1 wherein the at least one computer vision model and/or the at least one natural language processing model apply methods of artificial intelligence.

3. Method of any of the preceding claims, wherein the questions posed in the questionnaire(s) comprise objective questions and/or subjective questions.

4. Method of any of the preceding claims, wherein users answer(s) to the question(s) are turned into objective planning recommendation(s).

5. Method of any of the preceding claims, wherein knowledge graphs and/or reinforcement learning is applied.

6. Method of any of the preceding claims, wherein an agent is trained to make decisions based on feedback from the environment.

7. Method of any of the preceding claims, wherein images of living spaces provided by the user are analyzed for interior design features and/or color features and/or material features.

8. Method of any of the preceding claims, wherein social media profiles and/or documents uploaded by the user are analyzed for features.

9. Method of any of the preceding claims, wherein the documents provided by the user comprise floor plans and/or regulations and/or official papers.

10. Method of any of the preceding claims, wherein computer vision algorithms are used to analyze pictures and/or floor plans provided by customers to identify specific features, such as the number and/or location of rooms and/or the size of windows and/or the presence of specific materials.

11. Method of any of the preceding claims, wherein natural language processing techniques are used analyzing the text descriptions that accompany pictures and floor plans in order to extract keywords and phrases.

12. Method of any of the preceding claims, wherein keywords and phrases are extracted, which are relevant to the building industry.

13. Method of any of the preceding claims, wherein at least one intelligent mood board is created by the user and features are extracted from it.

14. Method of any of the preceding claims, wherein building and room usage plan(s) are generated automatically.

15. Data processing apparatus comprising means for carrying out the method of any of the preceding claims.

16. Computer program comprising instructions which, when the program is executed by a computer, cause the computer to carry out the method of any of Claim 1 through Claim 15.

17. Data carrier signal carrying the computer program of Claim 16.
